# EUROPEAN PATENT SPECIFICATION

(11) **EP 3 297 041 B1**
(45) Date of publication and mention of the grant of the patent: **22.11.2023**
(21) Application number: 17191159.7
(22) Date of filing: 14.09.2017
(51) Int. Cl.: H01L 31/05, H01L 31/0352, H01L 31/042, H01L 31/044

(54) **POWER ROUTING MODULE FOR A SOLAR CELL ARRAY**
STROMLEITUNGSMODUL FÜR EINE SOLARZELLENANORDNUNG
MODULE D'ACHEMINEMENT DE PUISSANCE POUR UN RÉSEAU DE CELLULES SOLAIRES

(30) Priority: 14.09.2016 US 201662394649 P; 14.09.2016 US 201662394636 P; 14.09.2016 US 201662394616 P; 14.09.2016 US 201662394623 P; 14.09.2016 US 201662394627 P; 14.09.2016 US 201662394629 P; 14.09.2016 US 201662394632 P; 14.09.2016 US 201662394666 P; 14.09.2016 US 201662394667 P; 14.09.2016 US 201662394671 P; 14.09.2016 US 201662394641 P; 14.09.2016 US 201662394672 P; 06.07.2017 US 201715643282; 06.07.2017 US 201715643274; 06.07.2017 US 201715643277; 06.07.2017 US 201715643279; 06.07.2017 US 201715643285; 06.07.2017 US 201715643287; 06.07.2017 US 201715643289
(43) Date of publication of application: 21.03.2018
(60) Divisional application: 23197851.1
(73) Proprietor: The Boeing Company, Arlington, VA 22202 (US)
(72) Inventor: REHDER, Eric, Chicago, 60606-1596 (US)
(74) Representative: Witte, Weller & Partner Patentanwälte mbB

(56) References cited:
- WO-A1-2009/012567
- JP-A- 2011 071 214
- US-A- 5 391 235
- US-A1- 2012 167 954
- US-A1- 2015 062 834
- US-A1- 2016 218 665
- US-B1- 6 313 396

## Description

### BACKGROUND INFORMATION

### 1. Field.

The disclosure is related generally to solar cell panels and, more specifically, to a power routing module for a solar cell array.

### 2. Background.

Typical spaceflight-capable solar cell panel assembly involves building long strings of solar cells. These strings are variable in length and can be very long, for example, up to and greater than 20 cells. Assembling such long, variable, and fragile materials is difficult, which has prevented automation of the assembly.

Existing solutions use solar cells assembled into CIC (cell, interconnect and coverglass) units. The CIC has metal foil interconnects connected to the front of the cell that extend in parallel from one side of the CIC. The CICs are located close to each other and the interconnects make connection to the bottom of an adjacent cell. Using these interconnects, the CICs are assembled into linear strings. These linear strings are built-up manually and then laid out to form a large solar cell array comprised of many strings of variable length.

Additionally, a bypass diode is used to protect the cells from reverse bias, when the cells become partially shadowed. The bypass diode generally connects the back contacts of two adjacent cells within the solar cell array.

When used in a satellite, the solar cell array is typically packaged as a panel. The dimensions of the panel are dictated by the needs of the satellite, including such constraints as needed power, as well as the size and shape necessary to pack and store the satellite in a launch vehicle. Furthermore, the deployment of the panel often requires that some portions of the panel are used for the mechanical fixtures and the solar cell array must avoid these locations. In practice, the panel is generally rectangular, but its dimensions and aspect ratio vary greatly. The layout of the CICs and strings to fill this space must be highly customized for maximum power generation, which results in a fabrication process that is highly manual.

US 5,391,235 A discloses a solar cell module and method of manufacturing the same. WO 2009/012567 A1 discloses a shading protection for solar cells and solar cell modules. US 6,313,396 B 1 discloses a lightweight solar module and method of fabrication. US 2012/167954 A1 discloses a monolithic module assembly using back contact solar cells and metal ribbon. US 2016/218665 A1 discloses a space solar cell panel with blocking diodes. US 2015/0062834 A1 discloses a jumper module mounting circuit board and circuit board assembly JP 2011 071214 A discloses interconnector elements for interconnecting solar cells on a substrate.

What is needed, then, is a means for promoting automated manufacturing of solar arrays, while preserving the ability for customization of solar cell arrays.

### SUMMARY

There is provided a power routing module as defined in claim 1, wherein preferred embodiments thereof are defined in the dependent claims. A solar cell panel and a method for interconnecting solar cells is defined in the remaining independent claims.

### DRAWINGS

Referring now to the drawings in which like reference numbers represent corresponding parts throughout:
FIGS. 1 and 2 illustrate conventional structures for solar cell panels.
FIGS. 3A and 3B illustrate an improved structure for a solar cell panel, according to one example.
FIGS. 4A and 4B illustrate an alternative structure for the solar cell panel, according to one example.
FIG. 5 illustrates the front side of an exemplary solar cell that may be used in the improved solar cell panel of FIGS. 3A-3B and 4A-4B.
FIG. 6 illustrates the back side of the exemplary solar cell of FIG. 5.
FIG. 7 illustrates cells arranged into a two-dimensional (2D) grid of an array, according to one example.
FIG. 8 illustrates an example of the array where one or more bypass diodes are added to the exposed area of the substrate in the corner regions.
FIG. 9 illustrates an example where the bypass diode is applied to the back side of the cell, with an interconnect or contact for the bypass diode extending into the corner region between front and back contacts.
FIG. 10 illustrates a front side view of the example of FIG. 9, with the interconnect or contact for the bypass diode extending into the corner region between the front and back contacts.
FIG. 11 illustrates the cells of FIGS. 9 and 10 arranged into the 2D grid of the array and applied to the substrate, where the bypass diodes are applied to the back side of the cells, with the contacts for the bypass diodes extending into the corner regions of the cells.
FIG. 12 shows up/down series connections between the cells of the array, according to one example.
FIG. 13 shows left/right series connections between the cells of the array, according to one example.
FIG. 14 is a schematic side view of an example with a substrate below and a power routing module above, wherein the substrate is a flex sheet assembly.
FIG. 15 is a schematic side view of an example with a substrate below and a power routing module above, with the power routing module attached to the flex sheet with an adhesive.
FIG. 16 is a top view of a corner region of solar cells in an array.
FIG. 17 shows the power routing module's structure for a series connection of the solar cells.
FIG. 18 shows a variation of the power routing module attached to the solar cells in the array.
FIG. 19 shows the layout for adjacent solar cells at the bottom of a column in the array before the power routing module is attached
FIG. 20 shows an example of the power routing module that connects between the solar cells in FIG. 19.
FIG. 21 shows another example of the power routing module that connects between the solar cells in FIG. 19.
FIG. 22 shows the layout for adjacent solar cells at the top of a column in the array before the power routing module is attached.
FIG. 23 shows an example of the power routing module that connects between the solar cells in FIG. 22.
FIG. 24 shows another example of the power routing module that connects between the solar cells in FIG. 22.
FIG. 25 shows the of an array of cells with the layout corresponding to the direction of the current as determined by the power routing modules.
FIG. 26 shows the layout of FIG. 25 with cells removed, and the bottom power routing modules moved, in order to form a non-rectangular array of solar cells using the power routing modules.
FIG. 27 shows the layout of FIG. 25 with cells removed, and the bottom power routing modules moved, in order to define a stayout zone.
FIG. 28 describes a method of fabricating a solar cell, solar cell panel and/or satellite, according to one example.
FIG. 29 illustrates a resulting satellite having a solar cell panel comprised of solar cells, according to one example.
FIG. 30 is an illustration of the solar cell panel in the form of a functional block diagram, according to one example.

### DETAILED DESCRIPTION

In the following description, reference is made to the accompanying drawings which form a part hereof, and in which is shown by way of illustration a specific example in which the disclosure may be practiced. It is to be understood that other examples may be utilized and structural changes may be made without departing from the scope of the present disclosure.

### GENERAL DESCRIPTION

A new approach to the design of solar cell arrays, such as those used for spaceflight power applications, is based on electrical connections among the solar cells in the array.

This new approach rearranges the components of a solar cell and the arrangements of the solar cells in the array. Instead of having solar cells connected into long linear strings and then assembled onto a substrate, the solar cells are attached individually to a substrate, such that corner regions of adjacent cells are aligned on the substrate, thereby exposing an area of the substrate. Electrical connections between cells are made by corner conductors formed on or in the substrate in these corner regions. Consequently, this approach presents a solar cell array design based on individual cells.

Thus, a single laydown process and layout can be used in the fabrication of solar cell arrays. Current flow between solar cells will be assisted with conductors embedded in the substrate. These electrical connections define the specific characteristics of the solar cell array, such as its dimensions, stayout zones, and circuit terminations. This approach simplifies manufacturing, enables automation, and reduces costs and delivery times.

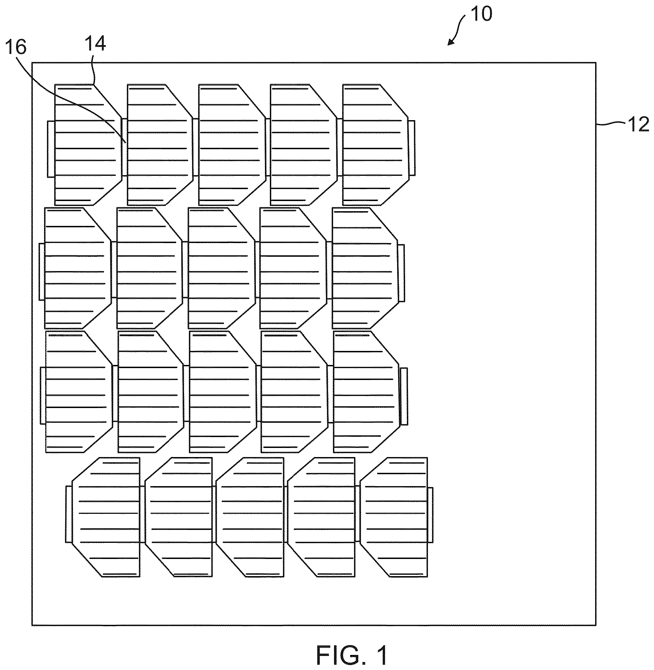

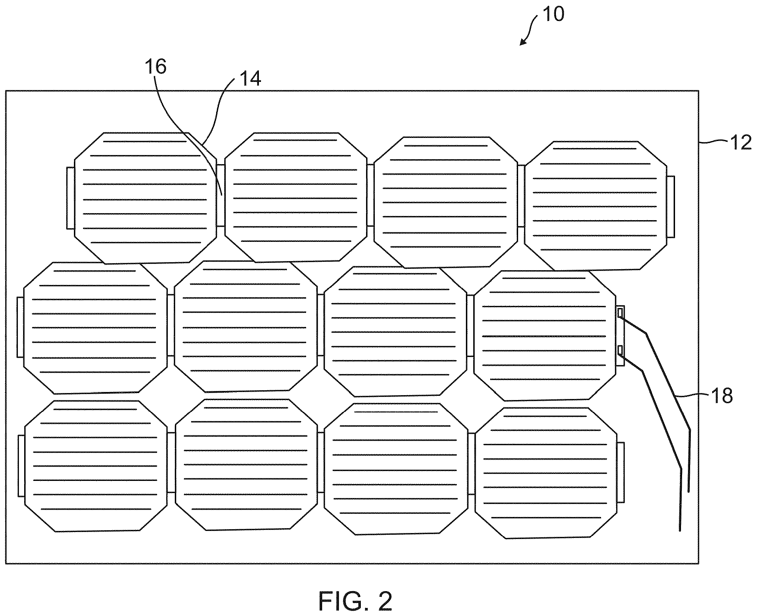

FIGS. 1 and 2 illustrate conventional structures for solar cell panels 10, which include a substrate 12, a plurality of solar cells 14 arranged in an array, and electrical connectors 16 between the solar cells 14. Half size solar cells 14 are shown in FIG. 1 and full size solar cells 14 are shown in FIG. 2. Space solar cells 14 are derived from a round Germanium (Ge) substrate starting material, which is later fabricated into semi-rectangular shapes to improve dense packing onto the solar cell panel 10. This wafer is often diced into one or two solar cells 14 herein described as half size or full size solar cells 14. The electrical connectors 16 providing electrical connections between solar cells 14 are made along the long parallel edge between solar cells 14. These series connections (cell-to-cell) are completed off-substrate, as strings of connected solar cells 14 are built having lengths of any number of solar cells 14. The completed strings of solar cells 14 are then applied and attached to the substrate 12.

In FIG. 2, wiring 18 is attached at the end of a string of solar cells 14 to electrically connect the string to other strings, or to terminate the resulting circuit and bring the current off of the array of solar cells 14. String-to-string and circuit termination connections are typically done on the substrate 12, and typically using wiring 18. However, some solar cell panels 10 use a printed circuit board (PCB)-type material with embedded conductors.

Adjacent strings of connected solar cells 14 can run parallel or anti-parallel. In addition, strings of connected solar cells 14 can be aligned or misaligned. There are many competing influences to the solar cell 14 layout resulting in regions where solar cells 14 are parallel or anti-parallel, aligned or misaligned.

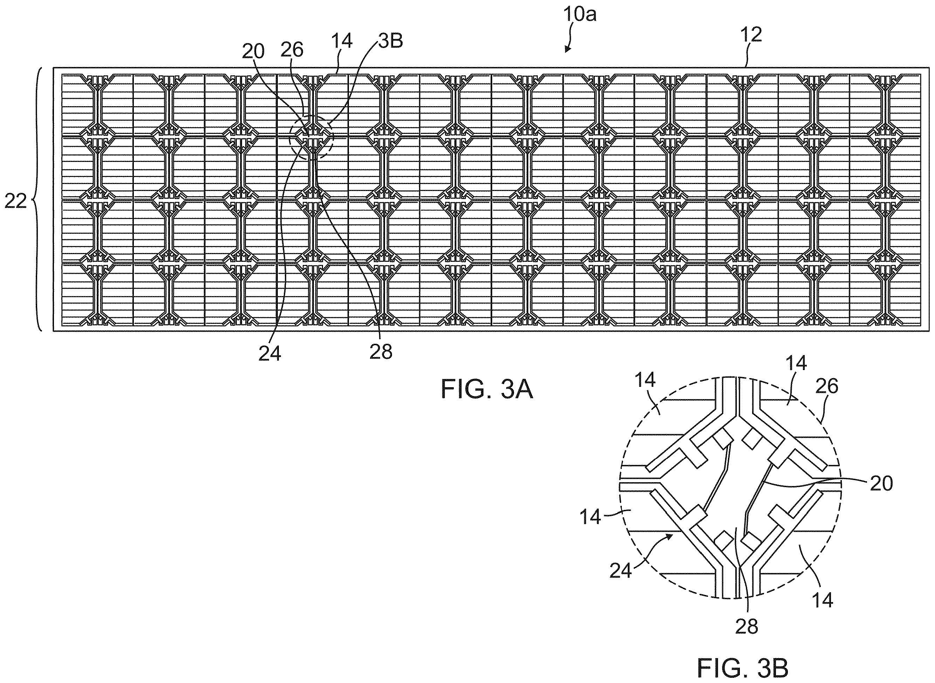

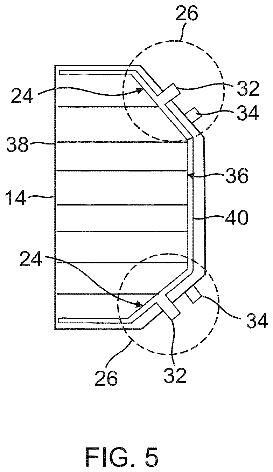

FIGS. 3A-3B illustrate improved devices and structures for a solar cell panel 10a, according to one example, wherein FIG. 3B is an enlarged view of the details in the dashed circle in FIG. 3A. The various components of the solar cell panel 10a are shown and described in greater detail in FIGS. 5-13.

The solar cell panel 10a includes a substrate 12 for solar cells 14 having one or more corner conductors 20 thereon. In one example, the substrate 12 is a multi-layer substrate 12 comprised of one or more Kapton^{®} (polyimide) layers separating one or more patterned metal layers. The substrate 12 may be mounted on a large rigid panel 10a similar to conventional assembles. Alternatively, substrate 12 can be mounted to a lighter more sparse frame or panel 10a for mounting or deployment.

A plurality of solar cells 14 are attached to the substrate 12 in a two-dimensional (2D) grid of an array 22. In this example, the array 22 is comprised of ninety-six (96) solar cells 14 arranged in four (4) rows by twenty-four (24) columns, but it is recognized that any number of solar cells 14 may be used in different implementations.

At least one of the solar cells 14 has at least one cropped corner 24 that defines a corner region 26, as indicated by the dashed circle. The solar cells 14 are attached to the substrate 12, such that corner regions 26 of adjacent ones of the solar cells 14 are aligned, thereby exposing an area 28 of the substrate 12. The area 28 of the substrate 12 that is exposed includes one or more of the corner conductors 20, and one or more electrical connections between the solar cells 14 and the corner conductors 20 are made in the corner regions 26 resulting from the cropped corners 24 of the solar cells 14.

In this example, the corner conductors 20 are conductive paths attached to, printed on, buried in, or deposited on the substrate 12, before and/or after the solar cells 14 are attached to the substrate 12, which facilitate connections between adjacent solar cells 14. The connections between the solar cells 14 and the corner conductors 20 are made after the solar cells 14 have been attached to the substrate 12.

Four adjacent solar cells 14 are aligned on the substrate 12, such that four cropped corners 24, one from each solar cell 14, are brought together at the corner regions 26. The solar cells 14 are then individually attached to the substrate 12, wherein the solar cells 14 are placed on top of the corner conductors 20 to make the electrical connection between the solar cells 14 and the corner conductors 20.

The solar cells 14 can be applied to the substrate 12 as CIC (cell, interconnect and coverglass) units. Alternatively, bare solar cells 14 can be assembled on the substrate 12, and then interconnects applied to the solar cells 14, followed by the application of a single solar cell 14 coverglass, multiple solar cell 14 coverglass, multiple solar cell 14 polymer coversheet, or spray encapsulation. This assembly protects the solar cells 14 from damage that would limit performance.

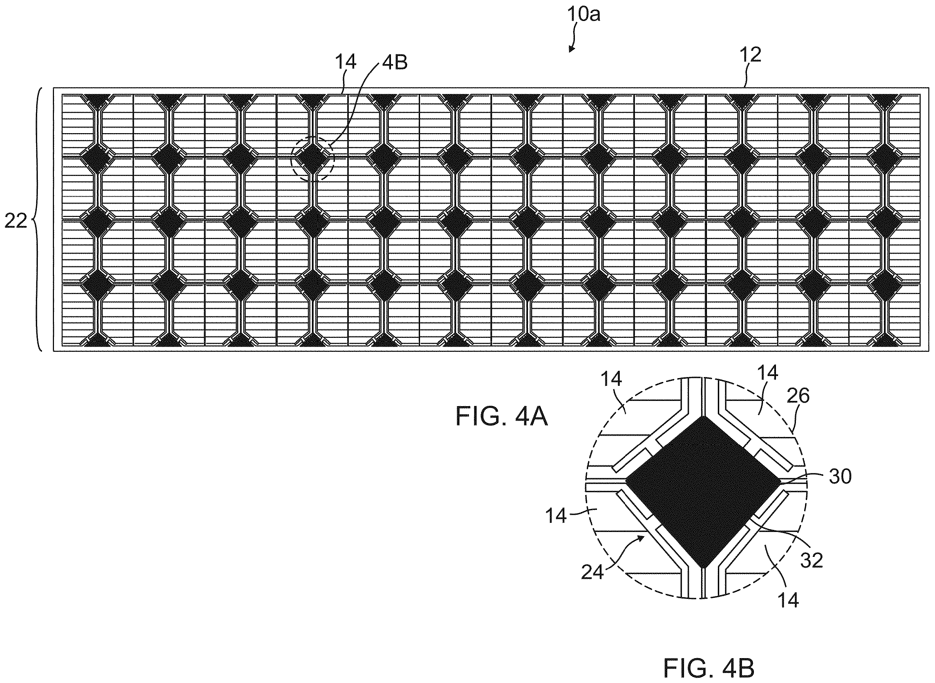

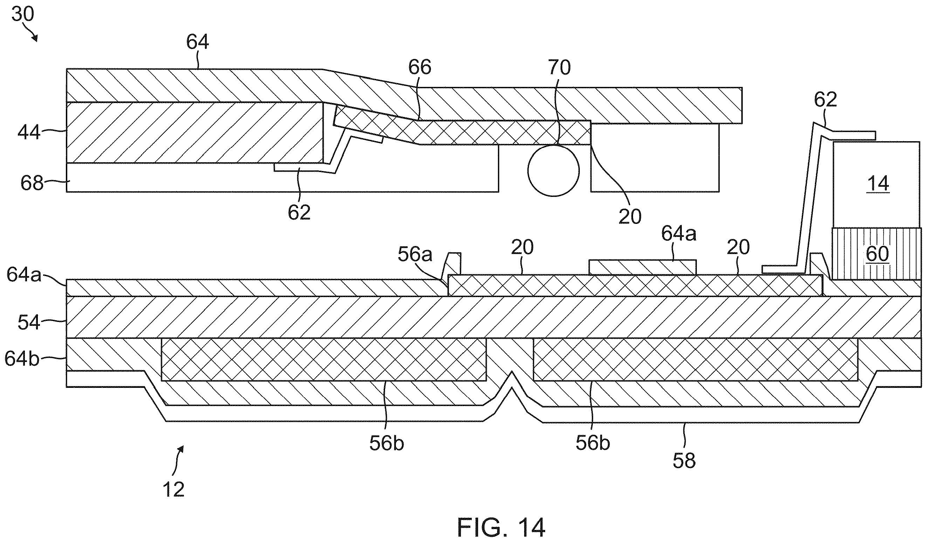

FIGS. 4A and 4B illustrate an alternative structure for the solar cell panel 10a, according to one example, wherein FIG. 4B is an enlarged view of the details in the dashed circle in FIG. 4A. In this example, only a few corner conductors 20 are printed on or integrated with the substrate 12. Instead, most of the corner conductors 20 are contained within a power routing module (PRM) 30 that is attached to the substrate 12, as described in more detail below in conjunction with FIGS. 14-27.

FIG. 5 illustrates the front side of an exemplary solar cell 14 that can be used in the improved solar cell panel 10a of FIGS. 3A-3B and 4A-4B. The solar cell 14, which is a CIC unit, is a half-size solar cell 14. (Full-size solar cells 14 could also be used.)

The solar cell 14 is fabricated having at least one cropped corner 24 that defines a corner region 26, as indicated by the dashed circle, such that the corner region 26 resulting from the cropped corner 24 includes at least one contact 32, 34 for making an electrical connection to the solar cell 14. In the example of FIG. 5, the solar cell 14 has two cropped corners 24, each of which has both a front contact 32 on the front side of the solar cell 14 and a back contact 34 on a back side of the solar cell 14, where the contacts 32 and 34 extend into the corner region 26. (Full-size solar cells 14 would have four cropped corners 24, each of which would have a front contact 32 and a back contact 34.)

The cropped corners 24 increase utilization of the round wafer starting materials for the solar cells 14. In conventional panels 10, these cropped corners 24 would result in unused space on the panel 10 after the solar cells 14 are attached to the substrate 12. The new approach described in this disclosure, however, utilizes this unused space. Specifically, metal foil interconnects, comprising the corner conductors 20, front contacts 32 and back contacts 34, are moved to the corner regions 26. In contrast, existing CICs have interconnects attached to the solar cell 14 front side, and connect to the back side (where connections occur) during stringing.

The current generated by the solar cell 14 is collected on the front side of the solar cell 14 by a grid 36 of thin metal fingers 38 and wider metal bus bars 40 that are connected to both of the front contacts 32. There is a balance between the addition of metal in grid 36, which reduces the light entering the solar cell 14 and its output power, and the reduced resistance of having more metal. The bus bar 40 is a low resistance conductor that carries high currents and also provides redundancy should a front contact 32 become disconnected. Optimization generally desires a short bus bar 40 running directly between the front contacts 32. Having the front contact 32 in the cropped corner 24 results in moving the bus bar 40 away from the perimeter of the solar cell 14. This is achieved while simultaneously minimizing the bus bar 40 length and light obscuration. Additionally, the fingers 38 are now shorter. This reduces parasitic resistances in the grid 36, because the length of the fingers 38 is shorter and the total current carried is less. This produces a design preference where the front contacts 32 and connecting bus bar 40 is moved to provide shorter narrow fingers 38.

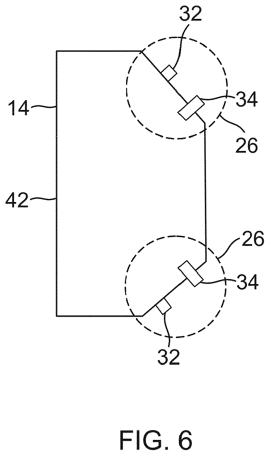

FIG. 6 illustrates the back side of the exemplary solar cell 14 of FIG. 5. The back side of the solar cell 14 has a back layer 42 that is connected to both of the back contacts 34.

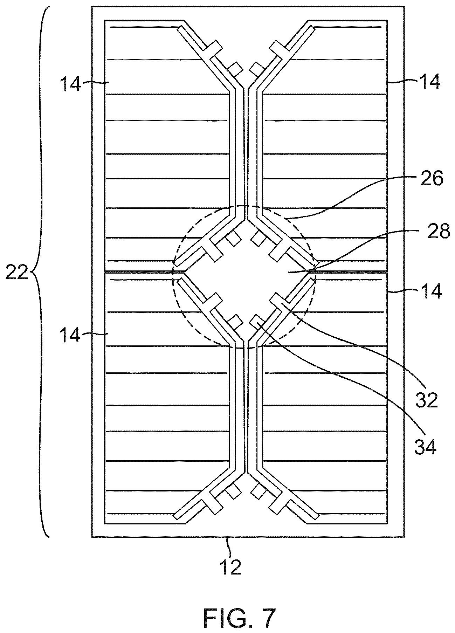

FIG. 7 illustrates solar cells 14 arranged into the 2D grid of the array 22, according to one example. The array 22 comprises a plurality of solar cells 14 attached to a substrate 12, such that corner regions 26 of adjacent ones of the solar cells 14 are aligned, thereby exposing an area 28 of the substrate 12. Electrical connections (not shown) between the solar cells 14 are made in the exposed area 28 of the substrate 12 using the front contacts 32 and back contacts 34 of the solar cells 14 and corner conductors 20 (not shown) formed on or in the exposed area 28 of the substrate 12.

During assembly, the solar cells 14 are individually attached to the substrate 12. This assembly can be done directly on a support surface, i.e., the substrate 12, which can be either rigid or flexible. Alternatively, the solar cells 14 could be assembled into the 2D grid of the array 22 on a temporary support surface and then transferred to a final support surface, i.e., the substrate 12.

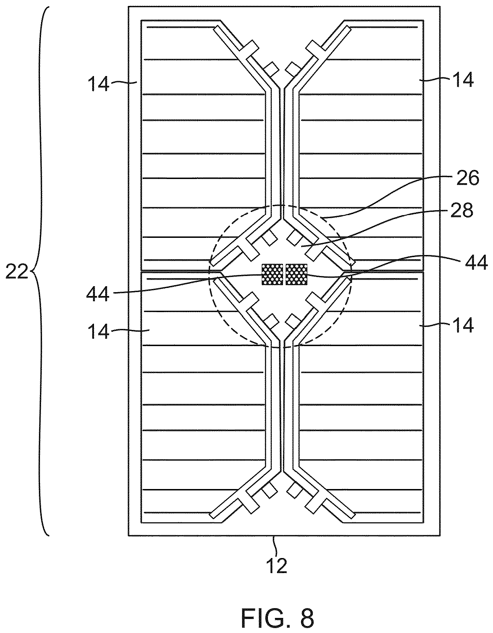

FIG. 8 illustrates an example of the array 22 where one or more bypass diodes 44 are added to the exposed area 28 of the substrate 12 in the corner regions 26, for use in one or more of the electrical connections. The bypass diodes 44 protect the solar cells 14 when the solar cells 14 become unable to generate current, which could be due to being partially shadowed, which drives the solar cells 14 into reverse bias. In one example, the bypass diodes 44 are attached to the substrate 12 in the corner regions 26 independent of the solar cells 14.

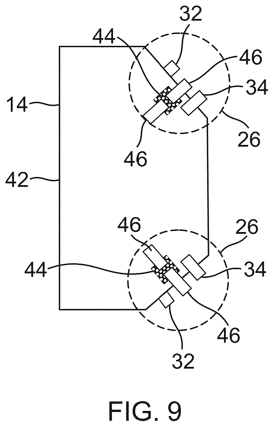

FIG. 9 illustrates an example where the bypass diode 44 is applied to the back side of the solar cell 14, with interconnects or contacts 46 for the bypass diode 44, one of which extends into the corner region 26 between the front and back contacts 32, 34.

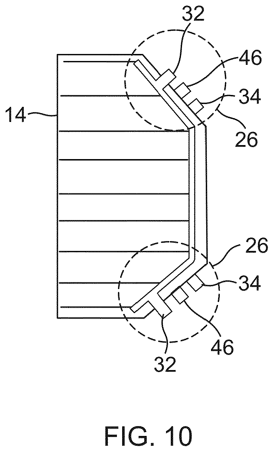

FIG. 10 illustrates a front side view of the example of FIG. 9, with the interconnect or contact 46 for the bypass diode 44 (not shown) extending into the corner region 26 between the front and back contacts 32, 34.

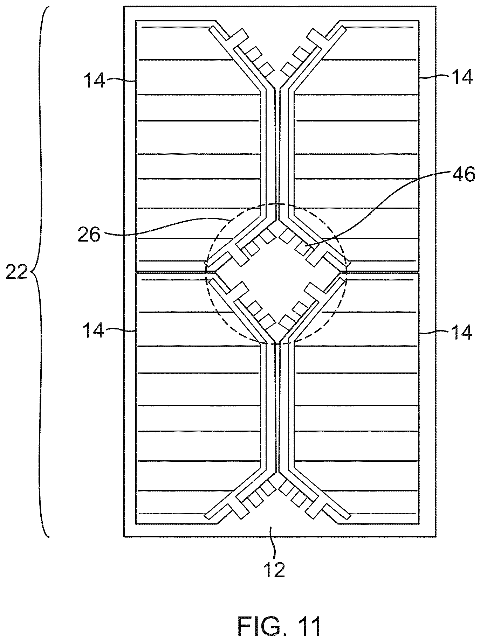

FIG. 11 illustrates the solar cells 14 of FIGS. 9 and 10 arranged into the 2D grid of the array 22 and applied to the substrate 12, where the bypass diodes 44 (not shown) are applied to the back side of the solar cells 14, with the contacts 46 for the bypass diodes 44 extending into the corner regions 26 of the solar cells 14.

One advantage of this approach is that the layouts illustrated in FIGS. 7, 8 and 11 are generalized layouts. Specifically, these layouts can be repeated across any panel 10a dimensions desired by a customer. This greatly simplifies assembly, rework, test, and inspection processes.

Following solar cell 14 and bypass diode 44 placement, there is another step where customization is accomplished. The front contacts 32 and back contacts 34 in the corner regions 26 of the solar cells 14 must be connected. This can be done in many combinations in order to route current through a desired path.

After attaching solar cells 14 to the substrate 12, connections are made between the solar cells 14 and the corner conductors 20. Front and back contacts 32, 34 of the solar cells 14 are present in each corner region 26 for attachment to the corner conductors 20. Interconnects for the front and back contacts 32, 34 of each of the solar cells 14 are welded, soldered, or otherwise bonded onto the corner conductors 20 to provide a conductive path 20, 32, 34 for routing current out of the solar cells 14.

Using the corner conductors 20, any customization can be made in the electrical connections. Adjacent solar cells 14 can be electrically connected to flow current in up/down or left/right directions as desired by the specific design. Current flow can also be routed around stayout zones as needed. The length or width of the solar cell array 22 can be set as desired. Also, the width can vary over the length of the array 22.

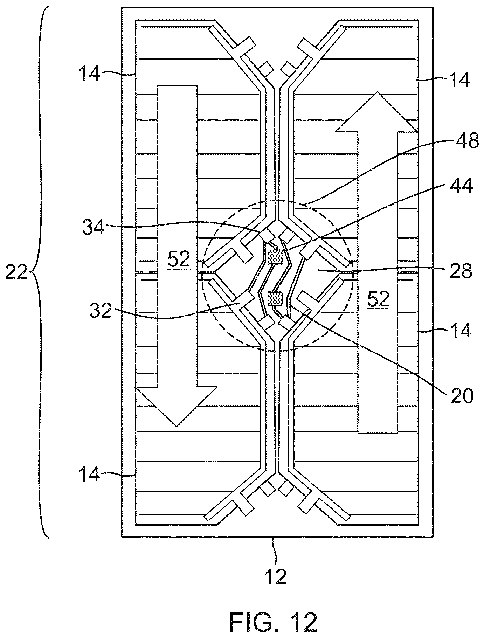

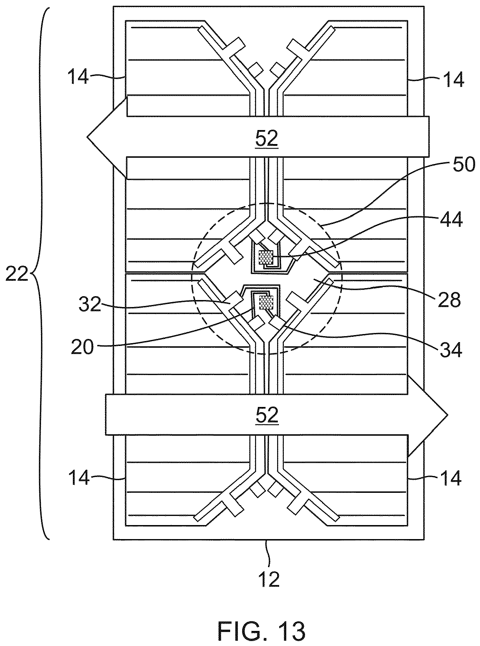

In one example, the electrical connections are series connections that determine a flow of current through the plurality of solar cells 14. This may be accomplished by the connection schemes shown in FIGS. 12 and 13, wherein FIG. 12 shows up/down series connections 48 between the solar cells 14 of the array 22, and FIG. 13 shows left/right series connections 50 between the solar cells 14 of the array 22. In both FIGS. 12 and 13, these series connections 48, 50 are electrical connections between the front contacts 32 and back contacts 34 of the solar cells 14, and the bypass diodes 44, are made using the corner conductors 20 formed on or in the exposed areas 28 of the substrate 12. These series connections 48, 50 determine the current (power) flow, as indicated by the arrows 52, through the solar cells 14, in contrast to the assembly of large strings off-substrate.

The corner conductors 20 between solar cells 14 can be in many forms. They could be accomplished using wires that have electrical connections made on both ends, which could be from soldering, welding, conducting adhesive, or other process. In addition to wires, metal foil connectors, similar to the interconnects, could be applied. Metal conductive paths or traces (not shown) can also be integrated with the substrate 12.

In summary, this new approach attaches the solar cells 14 individually to a substrate 12 such that the corner regions 26 of two, three or four adjacent solar cells 14 are aligned on the substrate 12. The solar cells 14 are laid out so that the cropped corners 24 are aligned and the corner regions 26 are adjacent, thereby exposing an area 28 of the substrate 12. Electrical connections between solar cells 14 are made in these corner regions 26 between front contacts 32 and back contacts 34 on the solar cells 14, bypass diodes 44, and corner conductors 20 on or in the exposed area 28 of the substrate 12, wherein these conductive paths are used to create a string of solar cells 14 in a series connection 48, 50 comprising a circuit.

### POWER ROUTING MODULE

While the use of electrical connections between solar cells 14 in the corner regions 26 facilitates automation, there is still a need for a variety of corner conductors 20 that can achieve various configurations to enable the customization needed by customers. However, this may require many corner conductors 20 in the corner regions 26, which would result in corner conductors 20 being closely spaced, raising electrostatic discharge (ESD) concerns.

On the other hand, to maximize power generation from the array of solar cells 14, it is desirable to have corner regions 26 as small as possible. Large solar cells 14 are also desirable for reducing labor and parts cost during assembly.

However, the design described herein changes this assessment, with the result that smaller solar cells 14 have little cost penalty. Smaller solar cells 14 have advantages in filling the wafer area, as well as filling the panels 10a. Smaller solar cells 14 mean better utilization of material and effort. However, smaller solar cells 14 also mean smaller cropped corners 24 and smaller corner regions 26, which causes problems for the connection strategy.

This disclosure describes the PRM 30 for customizing the corner conductors 20 used in the corner regions 26, wherein the PRM 30 is attached to the substrate 12 in the corner regions 26. Rather than form all of the corner conductors 20 on the substrate 12, most of the corner conductors 20 are contained within the PRM 30. Different versions of the PRM 30 having different conductor 20 layouts (e.g., 2D or 3D) can be selected to produce the desired connection layout for the array 22.

FIG. 14 is a schematic side view of an example with a substrate 12 below and a PRM 30 above, wherein the substrate 12 is a flex sheet assembly, according to one example. The substrate 12 includes a polyimide base layer 54 with Copper (Cu) layer 56a above and Cu layer 56b below, wherein Cu layers 56a and 56b form a multilayer conductor. The Cu layer 56a is patterned as the corner conductors 20, and the Cu layer 56b is patterned to form buried conductors within the substrate 12, including, for example, V+, V-, and bridging lines. A conducting back sheet of polyimide 58 can be applied to the substrate 12, which is useful in a space environment in that it will reduce the accumulation of charge.

Shown on the right side is the solar cell 14 that is attached to the substrate 12 with adhesive 60. Also visible is the metal foil interconnect 62 attached to the solar cell 14 and the corner conductors 20.

The substrate 12 also includes insulating layers that separate at least one of the multilayer conductors 56a, 56b from at least another one of the multilayer conductors 56a, 56b. In one example, there are a top polyimide overlay layer 64a and bottom polyimide overlay layer 64b. Polyimide has a high breakdown strength, greater than air or vacuum, and the polyimide overlay layers 64a, 64b are useful for preventing ESD, which is an important concern in a space environment.

The PRM 30 is positioned above the substrate 12 for electrically interconnecting the solar cells 14 in the array 22. The PRM 30 is comprised of an insulation layer comprising a polyimide base layer 64 and an electrically conductive layer comprising a single Cu layer 66 deposited thereon. The Cu layer 66, which comprises one or more corner conductors 20, is used for electrically interconnecting the solar cells 14, and the polyimide base layer 64 is used for electrically insulating the corner conductors 20 of the Cu layer 66.

While the base layer 64 of the PRM 30 is shown as being polyimide, it could be chosen from a wide variety of insulators that are suitable in the use environment, including other suitable polymers, as well as ceramics, such as glass or alumina. An advantage of glass or other transparent insulators is that these could be used with a laser welding process, where the laser beam is transmitted through the insulator and the laser beam's energy is absorbed by the conductive layer 66 on the PRM 30.

The top (sun facing side) of the PRM 30 could have a highly reflective coating, such as an Al foil bonded to the polyimide. This will reflect the solar energy away reducing heating of the solar array 22 and reducing the solar cells 14 operating temperature, which will increase power generation.

The PRM 30 may include a bypass diode 44 for protecting the solar cells 14 from a reverse bias, wherein the bypass diode 44 is connected to one or more of the corner conductors 20 of the PRM 30 by an interconnect 62. The PRM 30 may also include an adhesive 68 for attaching the PRM 30 to the substrate 12 and an electrical joint 70 for connecting one or more of the corner conductors 20 of the PRM 30 to one or more of corner conductors 20 of the substrate 12.

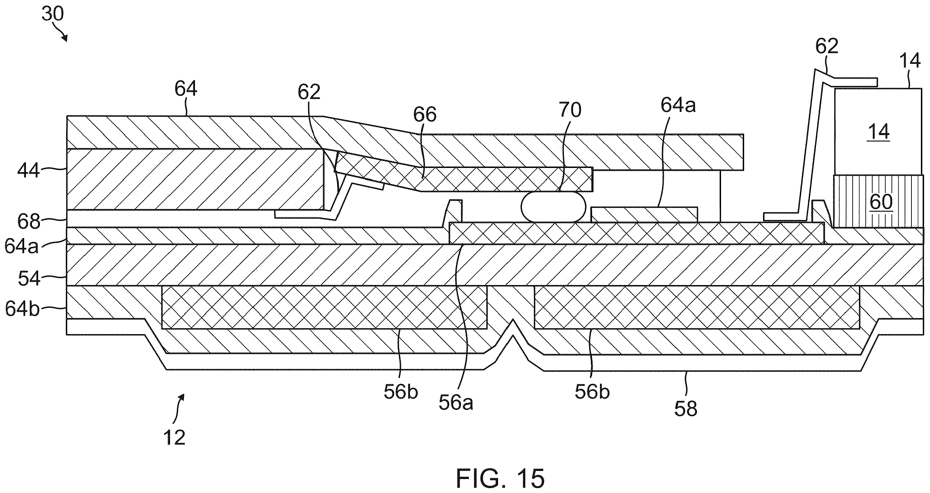

FIG. 15 is a schematic side view of the example from FIG. 14, with the PRM 30 attached to the substrate 12 using the adhesive 68. The PRM 30 is attached to the substrate 12 in the area 28 of the substrate 12 in the corner region 26 that remains exposed. In this example, an electrical connection is formed by the electrical joint 70 sandwiched between one or more of the corner conductors 20 of the PRM 30 and one or more of corner conductors 20 of the substrate 12, e.g., between the Cu layers 56a and 66. The electrical joint 70 could be accomplished with solder, via a laser welding process as described above, or via an ultrasonic welding process.

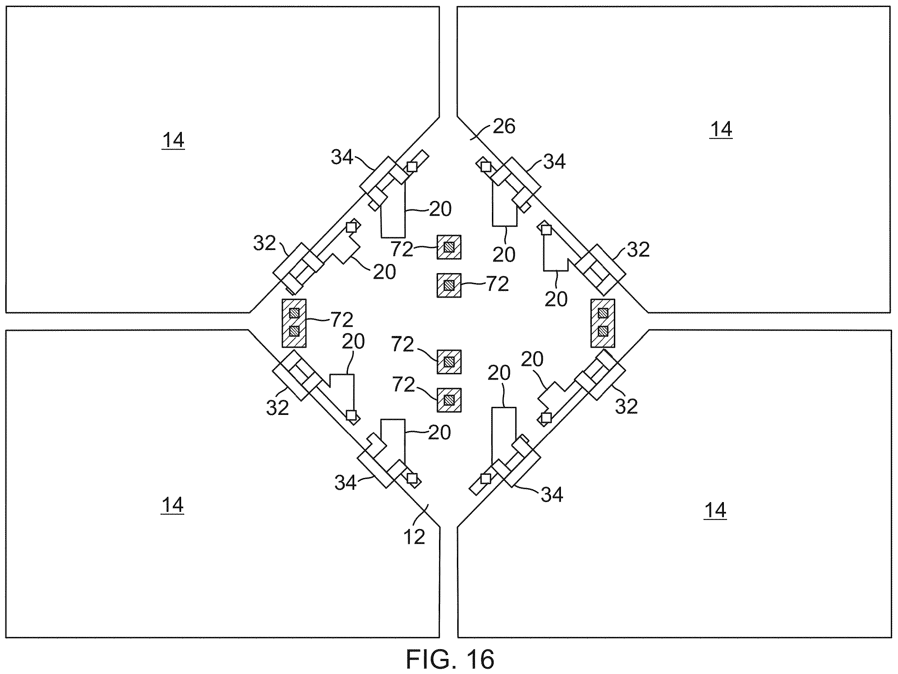

FIG. 16 shows a top view of the corner regions 26 of the solar cells 14 in the array 22, including the front and back contacts 32, 34, without the PRM 30 attached. There are fewer corner conductors 20 shown in this view. Also, the area 28 of the substrate 12 in the corner region 26 that remains exposed includes conducting pads 72 that provide connection points between the PRM 30 and conductive paths in the substrate 12, e.g., power lines, bridging lines or other conductive paths buried or embedded within the substrate 12 (i.e., Cu layer 56b). This is a common design for all corner regions 26 independent of application and PRM 30.

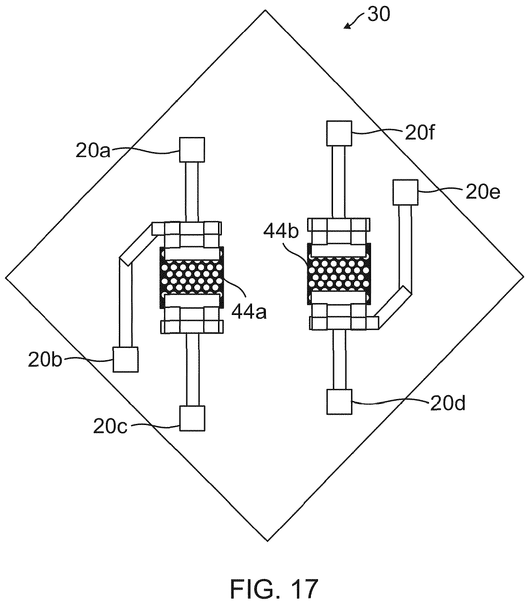

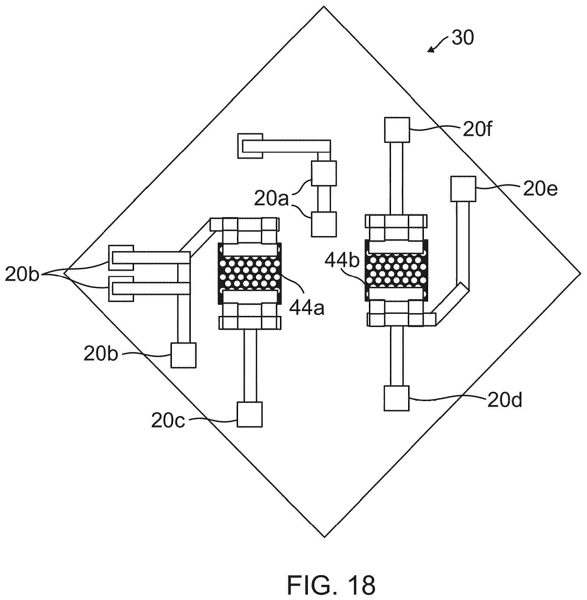

FIG. 17 shows one example where the PRM 30 electrically interconnects the solar cells 14 by providing a series connection 48 between the solar cells 14. Note that FIG. 17 shows the structure from the sun's perspective, looking through the polyimide base layer 64 (not shown) (the same is true for FIGS. 18, 20, 21, 23 and 24). Corner conductor 20a connects to the back contact 34 of the top left solar cell 14 (not shown), corner conductor 20b connects to the front contact 32 of the bottom left solar cell 14 (not shown), and corner conductor 20c connects to the back contact 34 of the bottom left solar cell 14 (not shown) through bypass diode 44a. Corner conductor 20d connects to the back contact 34 of the bottom right solar cell 14 (not shown), corner conductor 20e connects to the front contact 32 of the top right solar cell 14 (not shown), and corner conductor 20f connects to the back contact 34 of the top right solar cell 14 (not shown) through bypass diode 44b.

Note that, with minor modifications, the PRMs 30 can be rotated to change the functionality of the connections between solar cells 14. For example, the PRM 30 of FIG. 17 could be rotated to provide a left/right series connection 50.

FIG. 18 shows another example where the PRM 30 electrically interconnects the solar cells 14 with one or more power lines in the substrate 12. In this example, corner conductor 20a terminates the back contact 34 of the top left solar cell 14 (not shown) to pads 72 for a buried power+ line (not shown), corner conductor 20b terminates the front contact 32 of the bottom left solar cell 14 (not shown) to pads 72 for a buried power-(common) line (not shown), and corner conductor 20c connects to the back contact 34 of the bottom left solar cell 14 (not shown) through bypass diode 44a. Both corner conductors 20a, 20b have dual redundant connections to the pads 72 for the power+ and power- lines, although the number of connections could be increased or decreased if desired. Similar to FIG. 17, corner conductor 20d connects to the back contact 34 of the bottom right solar cell 14 (not shown), corner conductor 20e connects to the front contact 32 of the top right solar cell 14 (not shown), and corner conductor 20f connects to the back contact 34 of the top right solar cell 14 (not shown) through bypass diode 44b.

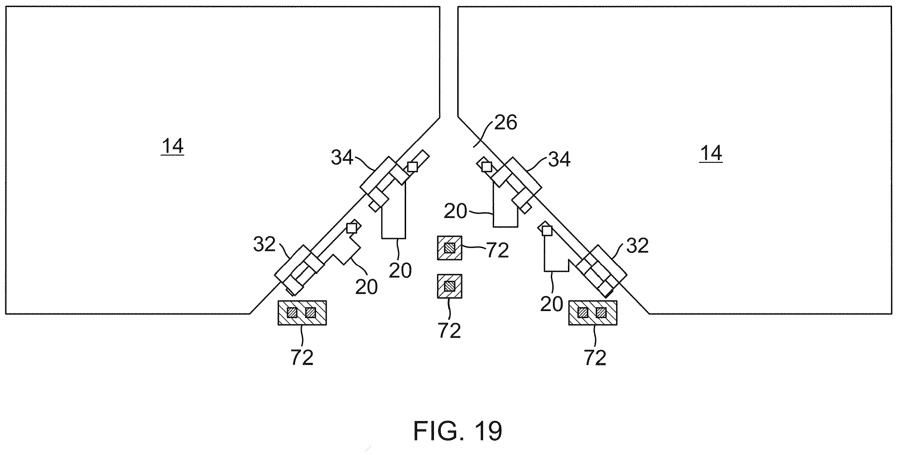

FIG. 19 shows the layout for adjacent solar cells 14 at the bottom of a column in the array 22 before the PRM 30 is attached, including corner conductors 20, corner regions 26, front and back contacts 32, 34, and conducting pads 72 associated with power lines, bridging lines or other conductive paths buried or embedded within the substrate 12.

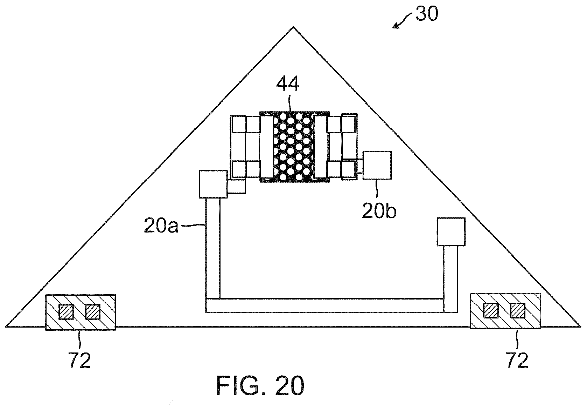

FIG. 20 shows an example where the PRM 30 electrically interconnects the solar cells 14 between columns of the solar cells 14 in FIG. 19. In this example, corner conductor 20a connects the back contact 34 of the left solar cell 14 (not shown) to the front contact 32 of the right solar cell 14 (not shown), and corner conductor 20b connects to the back contact 34 of the right solar cell 14 (not shown) through bypass diode 44.

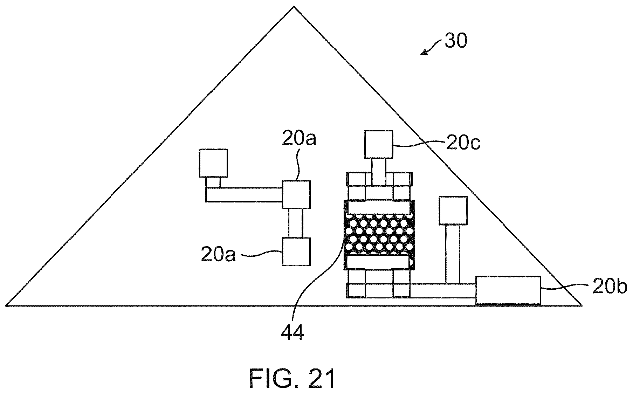

FIG. 21 shows another example where the PRM 30 electrically interconnects the solar cells 14 between columns of the solar cells 14 in FIG. 19. In this example, corner conductor 20a terminates the back contact 34 of the left solar cell 14 (not shown) to a pad 72 for a buried power+ line (not shown), corner conductor 20b terminates the front contact 32 of the right solar cell 14 (not shown) to a pad 72 for buried power- (common) line (not shown), and corner conductor 20c connects to the back contact 34 of the right solar cell 14 (not shown) through bypass diode 44. Only the corner conductor 20a has dual redundant connections to the pad 72 for the power+ line, although the number of connections could be increased or decreased if desired.

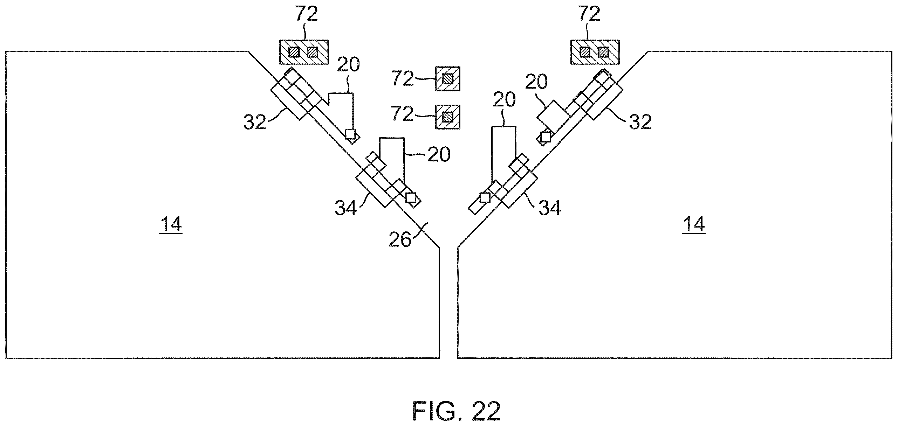

FIG. 22 shows the layout for adjacent solar cells 14 at the top of a column in the array 22 before the PRM 30 is attached, including corner conductors 20, corner regions 26, front and back contacts 32, 34, and conducting pads 72 associated with power lines, bridging lines or other conductive paths buried or embedded within the substrate 12.

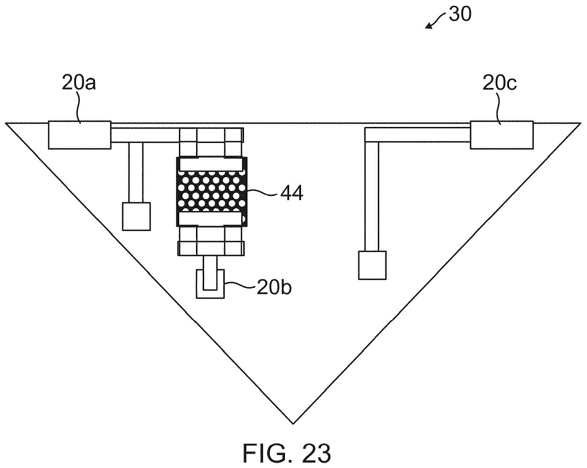

FIG. 23 shows an example where the PRM 30 electrically interconnects the solar cells 14 between columns of the solar cells 14 in FIG. 22. In this example, corner conductor 20a terminates the front contact 34 of the left solar cell 14 (not shown) to a pad 72 for a buried power- (common) line (not shown), corner conductor 20b connects to the back contact 34 of the left solar cell 14 (not shown) through bypass diode 44, and corner conductor 20c terminates the back contact 34 of the right solar cell 14 (not shown) to a pad 72 for a buried power- (common) line (not shown). This layout for the PRM 30 bridges the current from column-to-column in the array 22.

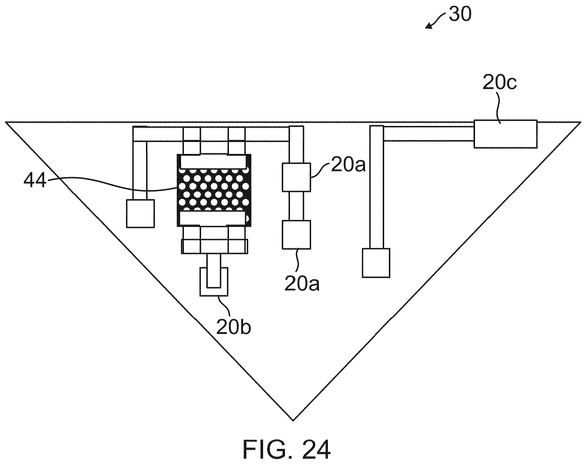

FIG. 24 shows another example where the PRM 30 electrically interconnects the solar cells 14 between columns of the solar cells 14 in FIG. 22. In this example, corner conductor 20a terminates the front contact 34 of the left solar cell 14 (not shown) to a pad 72 for a buried power+ line (not shown), corner conductor 20b connects to the back contact 34 of the left solar cell 14 (not shown) through bypass diode 44, and corner conductor 20c terminates the back contact 34 of the right solar cell 14 (not shown) to a pad 72 for a buried power- (common) line (not shown).

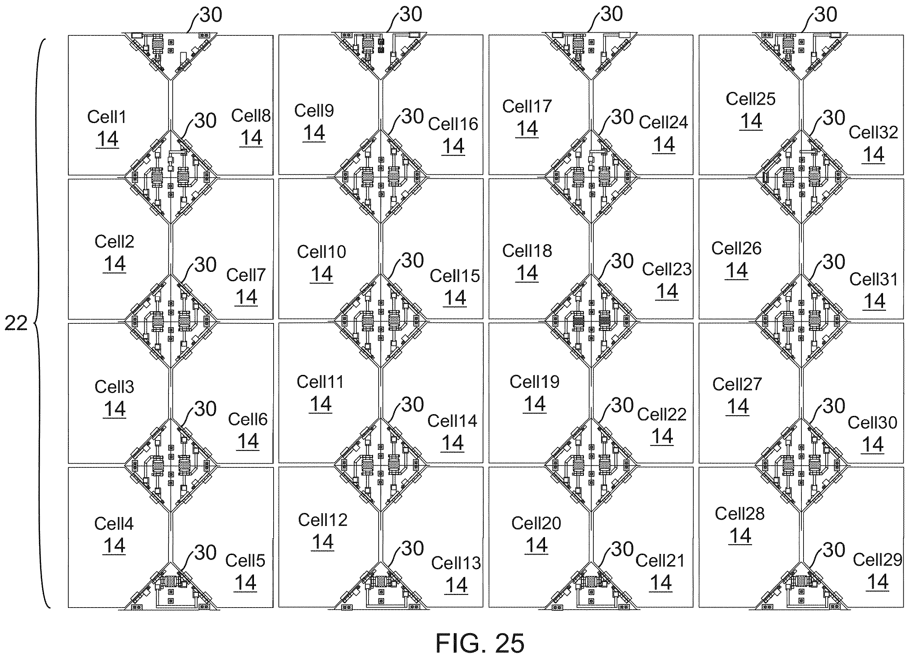

FIG. 25 shows the layout for an array 22 comprised of four (4) rows by eight (8) columns of solar cells 14, labeled as Cell 1 14 through Cell 32 14, with the numbering of the solar cell 14 labels corresponding to the direction of the current as determined by the PRMs 30 electrically interconnecting the solar cells 14 within columns of the solar cells 14. The PRMs 30 for the third/fourth, fifth/sixth, and seventh/eighth columns of the first row work in conjunction with the PRMs 30 in the first/second and fifth/sixth columns of the second row to terminate circuits between solar cells 14. The PRMs 30 in the bottom row bridge the current between the columns.

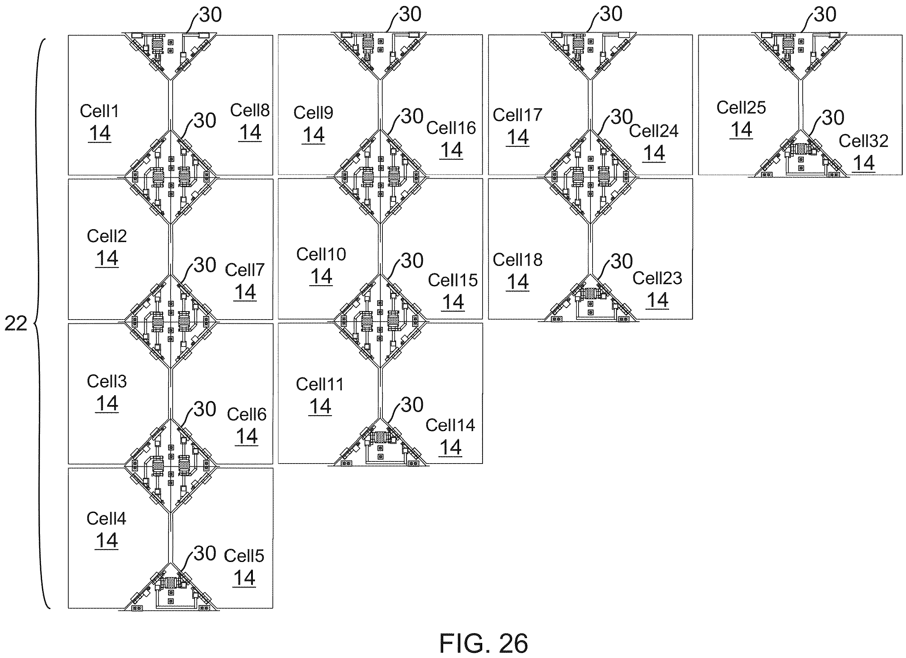

FIG. 26 shows the layout of FIG. 25 with Cell 12 14, Cell 13 14, Cell 19 14, Cell 20 14, Cell 21 14, Cell 22 14, Cell 26 14, Cell 27 14, Cell 28 14, Cell 29 14, Cell 30 14 and Cell 31 14 removed, and the bottom PRMs 30 moved up to terminate the third/fourth, fifth/sixth, and seventh/eighth columns, in order to form a non-rectangular array 22 of solar cells 14 using the PRMs 30 to electrically interconnect the solar cells 14 in the non-rectangular array 22.

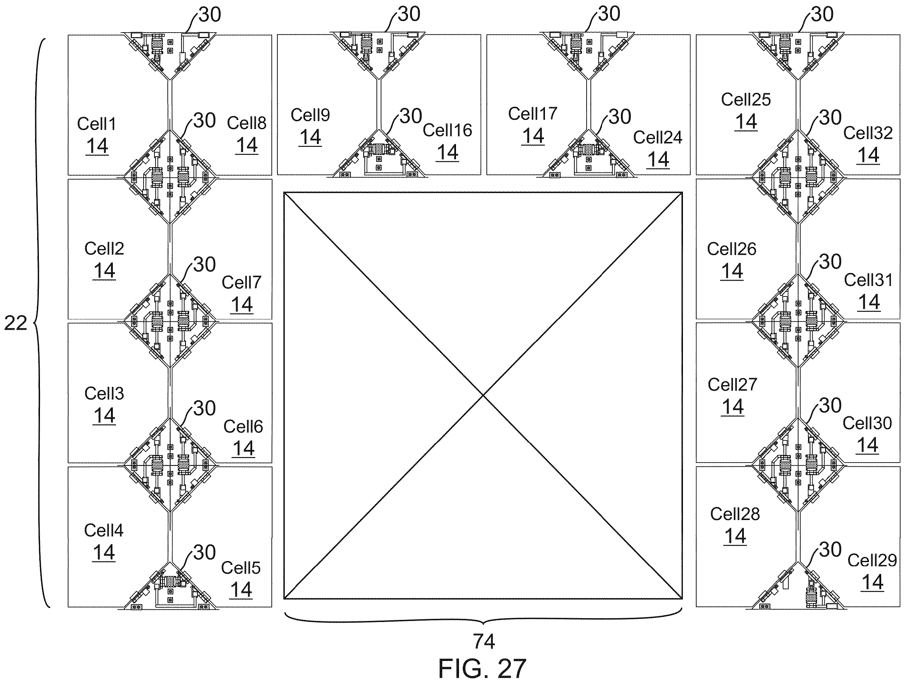

FIG. 27 shows the layout of FIG. 25 with Cell 10 14, Cell 1 14, Cell 12 14, Cell 13 14, Cell 14 14, Cell 15 14, Cell 18 14, Cell 19 14, Cell 20 14, Cell 21 14, Cell 22 14, Cell 23 14 removed, and the bottom PRMs 30 moved up to terminate the third/fourth and fifth/sixth columns and electrically interconnect the solar cells 14 by bridging connections around the removed solar cells 14, in order to define a stayout zone 74 The PRM 30 includes one or more corner conductors 20 for enabling the stayout zone 74, wherein current flows through bridge lines embedded within the substrate 12 (i.e., Cu layer 56b).

### FABRICATION

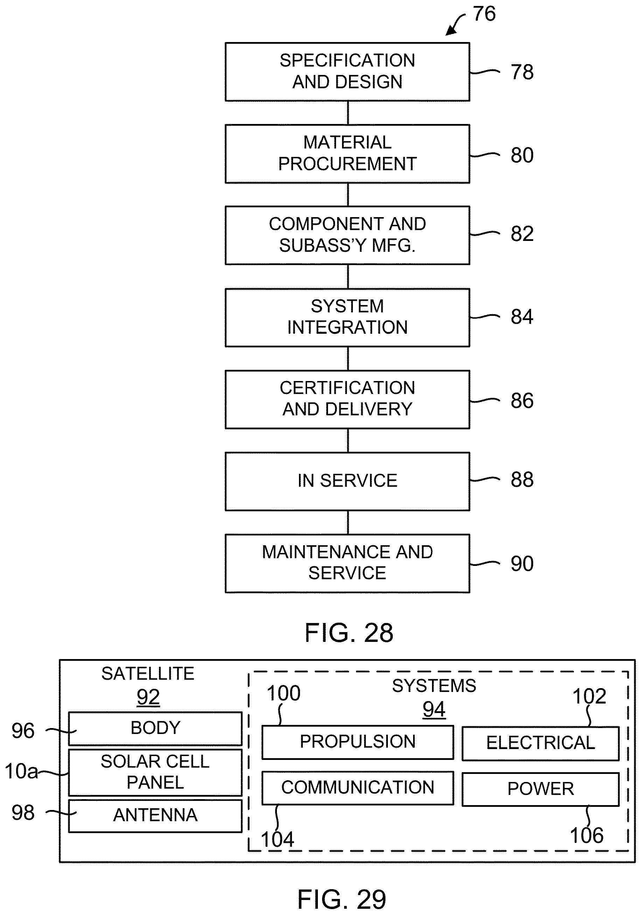

Examples of the disclosure may be described in the context of a method 76 of fabricating a solar cell 14, solar cell panel 10a and/or satellite, comprising steps 78-90, as shown in FIG. 28, wherein the resulting satellite 92 having a solar cell panel 10a comprised of solar cells 14 are shown in FIG. 29.

As illustrated in FIG. 28, during pre-production, exemplary method 76 may include specification and design 78 of the solar cell 14, solar cell panel 10a and/or satellite 92, and material procurement 80 for same. During production, component and subassembly manufacturing 82 and system integration 84 of the solar cell 14, solar cell panel 10a and/or satellite 92 takes place, which include fabricating the solar cell 14, solar cell panel 10a and/or satellite 92. Thereafter, the solar cell 14, solar cell panel 10a and/or satellite 92 may go through certification and delivery 86 in order to be placed in service 88. The solar cell 14, solar cell panel 10a and/or satellite 92 may also be scheduled for maintenance and service 90 (which includes modification, reconfiguration, refurbishment, and so on), before being launched.

Each of the processes of method 76 may be performed or carried out by a system integrator, a third party, and/or an operator (e.g., a customer). For the purposes of this description, a system integrator may include without limitation any number of solar cell, solar cell panel, satellite or spacecraft manufacturers and major-system subcontractors; a third party may include without limitation any number of venders, subcontractors, and suppliers; and an operator may be a satellite company, military entity, service organization, and so on.

As shown in FIG. 29, a satellite 92 fabricated by exemplary method 76 may include systems 94, a body 96, solar cell panels 10a comprised of solar cells 14, and one or more antennae 98. Examples of the systems 94 included with the satellite 92 include, but are not limited to, one or more of a propulsion system 100, an electrical system 102, a communications system 104, and a power system 106. Any number of other systems 94 also may be included.

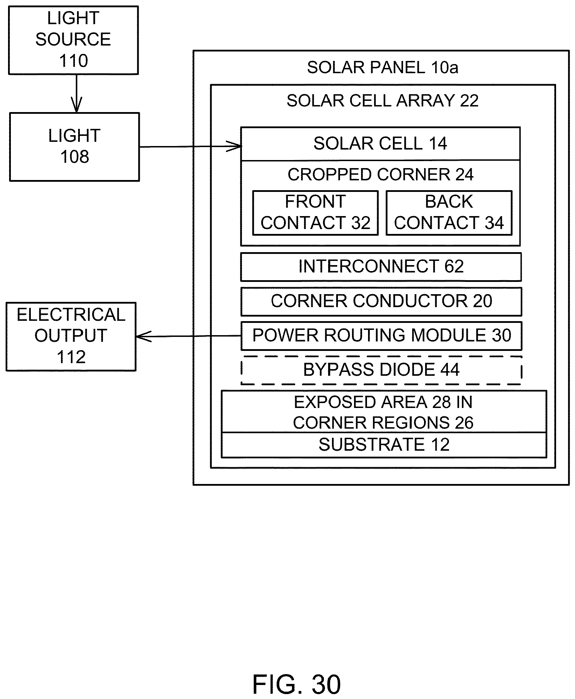

FIG. 30 is an illustration of the solar cell panel 10a in the form of a functional block diagram, according to one example. The solar cell panel 10a is comprised of the solar cell array 22, which is comprised of one or more of the solar cells 14 individually attached to the substrate 12. Each of the solar cells 14 absorbs light 108 from a light source 110 and generates an electrical output 112 in response thereto.

At least one of the solar cells 14 has at least one cropped corner 24 that defines a corner region 26, such that an area 28 of the substrate 12 remains exposed when the solar cell 14 is attached to the substrate 12. When a plurality of solar cells 14 are attached to the substrate 12, the corner regions 26 of adjacent ones of the solar cells 14 are aligned, thereby exposing the area 28 of the substrate 12.

The area 28 of the substrate 12 that remains exposed includes one or more corner conductors 20 attached to, printed on, or integrated with the substrate 12, and one or more electrical connections between the solar cells 14 and the corner conductors 20 are made in a corner region 26. The corner region 26 may also include one or more bypass diodes 44.

The corner region 26 includes at least one contact, for example, a front contact 32 on a front side of the solar cell 14 and/or a back contact 34 on a back side of the solar cell 14.

An interconnect 62 is used for making the electrical connections between the solar cell 14 and the corner conductors 20.

A power routing module 30 is attached to the exposed area 28 of the substrate 12 for electrically interconnecting solar cells 14 in the array 22, wherein the power routing module 30 includes a base layer 64, serving as an insulation layer, and an electrically conductive layer 66, the electrically conductive layer 66 is a conductor 20 for electrically interconnecting the solar cells 14, and the insulation layer 64 is used for electrically insulating the electrically conductive layer 66. The power routing module 30 may also include one or more bypass diodes 44, as well as an interconnect 62 connecting the bypass diode 44 to the electrically conductive layer 66.

There is disclosed a device, comprising: a power routing module for electrically interconnecting solar cells in an array, wherein the power routing module includes: an electrically conductive layer for electrically interconnecting the solar cells; and an insulation layer for electrically insulating the electrically conductive layer; wherein at least one of the solar cells has at least one cropped corner that defines a corner region; wherein an area of a substrate in the corner region remains exposed when the solar cells are attached to the substrate; and wherein the power routing module is attached to the substrate in the area of the substrate in the corner region that remains exposed.

The electrically conductive layer of the power routing module is comprised of one or more conductors.

Preferably, the power routing module includes a bypass diode for protecting the solar cells from a reverse bias and the bypass diode is connected to one or more of the conductors of the power routing module.

An electrical connection is formed by an electrical joint sandwiched between one or more of the conductors of the power routing module and one or more of conductors of the substrate.

The area of the substrate in the corner region that remains exposed includes conducting pads that provide connection points between the power routing module and conductive paths in the substrate.

Preferably, the power routing module electrically interconnects the solar cells with one or more power lines in the substrate.

Preferably, the power routing module electrically interconnects the solar cells by providing a series connection between the solar cells.

Preferably, the power routing module electrically interconnects the solar cells by bridging connections around the solar cells.

Preferably, the power routing module electrically interconnects the solar cells within columns of the solar cells.

Preferably, the power routing module electrically interconnects the solar cells between columns of the solar cells.

Preferably, the array is a non-rectangular array and the power routing module electrically interconnects the solar cells in the non-rectangular array.

Preferably, the power routing module includes one or more conductors for enabling a stayout zone.

The power routing module includes an adhesive for attaching to the substrate.

Further, there is disclosed a method, comprising: electrically interconnecting solar cells in an array using a power routing module, wherein the power routing module includes: an electrically conductive layer for electrically interconnecting the solar cells; and an insulation layer for electrically insulating the electrically conductive layer; wherein at least one of the solar cells has at least one cropped corner that defines a corner region; wherein an area of a substrate in the corner region remains exposed when the solar cells are attached to the substrate; and wherein the power routing module is attached to the substrate in the area of the substrate in the corner region that remains exposed.

The electrically conductive layer of the power routing module is comprised of one or more conductors.

Preferably, the power routing module includes a bypass diode for protecting the solar cells from a reverse bias and the bypass diode is connected to one or more of the conductors of the power routing module.

An electrical connection is formed by an electrical joint sandwiched between one or more of the conductors of the power routing module and one or more of conductors of the substrate.

The area of the substrate in the corner region that remains exposed includes conducting pads that provide connection points between the power routing module and conductive paths in the substrate.

Preferably, the power routing module electrically interconnects the solar cells with one or more power lines in the substrate.

Preferably, the power routing module electrically interconnects the solar cells by providing a series connection between the solar cells.

Preferably, the power routing module electrically interconnects the solar cells by bridging connections around the solar cells.

Preferably, the power routing module electrically interconnects the solar cells within columns of the solar cells.

Preferably, the power routing module electrically interconnects the solar cells between columns of the solar cells.

Preferably, the array is a non-rectangular array and the power routing module electrically interconnects the solar cells in the non-rectangular array.

Preferably, the power routing module includes one or more conductors for enabling a stayout zone.

The power routing module includes an adhesive for attaching to the substrate.

Also, there is disclosed a solar cell panel, comprising: a solar cell array comprised of at least one power routing module for electrically interconnecting solar cells in the array, wherein the power routing module includes: an electrically conductive layer for electrically interconnecting the solar cells; and an insulation layer for electrically insulating the electrically conductive layer; wherein at least one of the solar cells has at least one cropped corner that defines a corner region; wherein an area of a substrate in the corner region remains exposed when the solar cells are attached to the substrate; and wherein the power routing module is attached to the substrate in the area of the substrate in the corner region that remains exposed.

The electrically conductive layer of the power routing module is comprised of one or more conductors.

Preferably, the power routing module includes a bypass diode for protecting the solar cells from a reverse bias and the bypass diode is connected to one or more of the conductors of the power routing module.

An electrical connection is formed by an electrical joint sandwiched between one or more of the conductors of the power routing module and one or more of conductors of the substrate.

The area of the substrate in the corner region that remains exposed includes conducting pads that provide connection points between the power routing module and conductive paths in the substrate.

Preferably, the power routing module electrically interconnects the solar cells with one or more power lines in the substrate.

Preferably, the power routing module electrically interconnects the solar cells by providing a series connection between the solar cells.

Preferably, the power routing module electrically interconnects the solar cells by bridging connections around the solar cells.

Preferably, the power routing module electrically interconnects the solar cells within columns of the solar cells.

Preferably, the power routing module electrically interconnects the solar cells between columns of the solar cells.

Preferably, the array is a non-rectangular array and the power routing module electrically interconnects the solar cells in the non-rectangular array.

Preferably, herein the power routing module includes one or more conductors for enabling a stayout zone.

The power routing module includes an adhesive for attaching to the substrate.

The description of the examples set forth above has been presented for purposes of illustration and description, and is not intended to be exhaustive or limited to the examples described.

## Claims

1. A power routing module (30) for electrically interconnecting solar cells (14) in an array (22), when the solar cells (14) are attached to a substrate (12), wherein the power routing module (30) includes:
an electrically conductive layer (66) configured for electrically interconnecting the solar cells (14), wherein the electrically conductive layer (66) of the power routing module (30) is comprised of one or more corner conductors (20);
an insulation layer (64) configured for electrically insulating the electrically conductive layer (66);
an adhesive (68) for attaching the power routing module (30) to the substrate (12); and
an electrical joint (70) for connecting the one or more corner conductors (20) of the power routing module (30) to one or more corner conductors (20) of the substrate (12); wherein each of the solar cells (14) has at least one cropped corner (24) that defines a corner region (26), wherein the solar cells (14) are attached to the substrate (12) such that the corner regions (26) of adj acent ones of the solar cells (14) are aligned, thereby exposing an area (28) of the substrate (12);
wherein the area (28) of the substrate (12) in the corner regions (26) remains exposed when the solar cells (14) are attached to the substrate (12); and
wherein the power routing module (30) is attachable to the substrate (12) in the area (28) of the substrate (12) in the corner regions (26), that remains exposed when the solar cells (14) are attached to the substrate (12), such that an electrical connection is formed by the electrical joint (70) sandwiched between the one or more of corner conductors (20) of the power routing module (30) and the one or more corner conductors (20) of the substrate (12).

2. The power routing module (30) of claim 1, wherein the power routing module (30) includes a bypass diode (44) for protecting the solar cells (14) from a reverse bias and the bypass diode (44) is connected to the one or more of the conductors (20) of the power routing module (30).

3. The power routing module (30) of any of claims 1-2, wherein the area (28) of the substrate (12) in the corner regions (26) that remains exposed includes conducting pads (72) that provide connection points between the power routing module (30) and conductive paths in the substrate (12).

4. The power routing module (30) of any of claims 1-3, wherein the power routing module (30) is configured for electrically interconnecting the solar cells (14) with one or more power lines in the substrate (12).

5. The power routing module (30) of any of claims 1-4, wherein the power routing module (30) is configured for electrically interconnecting the solar cells (14) by providing a series connection between the solar cells (14).

6. The power routing module (30) of any of claims 1-5, wherein the power routing module (30) is configured for electrically interconnecting the solar cells (14) by bridging connections around the solar cells (14).

7. The power routing module (30) of any of claims 1-6, wherein the power routing module (30) is configured for electrically interconnecting the solar cells (14) within columns of the solar cells (14).

8. The power routing module (30) of any of claims 1-7, wherein the power routing module (30) is configured for electrically interconnecting the solar cells (14) between columns of the solar cells (14).

9. The power routing module (30) of any of claims 1-8, wherein the array (22) is a non-rectangular array and the power routing module (30) is configured for electrically interconnecting the solar cells (14) in the non-rectangular array.

10. The power routing module (30) of any of claims 1-9, wherein the power routing module (30) includes one or more conductors for enabling a stayout zone (74).

11. The power routing module (30) of any of claims 1-10 , wherein the insulation layer (64) is transparent.

12. The power routing module (30) of any of claims 1-11, wherein the electrical joint (70) is accomplished with solder, via a laser welding process or via an ultrasonic welding process.

13. A solar cell panel (10) comprising a solar cell array (22) and at least one power routing module (30) of any of claims 1-12.

14. A method, comprising:
electrically interconnecting solar cells (14) in an array (22) using a power routing module (30) of any of claims 1 to 12, wherein each of the solar cells (14) has at least one cropped corner (24) that defines a corner region (26), wherein the solar cells (14) are attached to a substrate (12) such that the corner regions (26) of adjacent ones of the solar cells (14) are aligned, thereby exposing an area (28) of the substrate (12);
attaching the solar cells (14) to the substrate (12) such that the area (28) of the substrate (12) in the corner regions (26) remains exposed; and
attaching the power routing module (30) to the substrate (12) in the area (28) of the substrate (12) in the corner regions (26) that remains exposed such that the electrical connection is formed by the electrical joint (70) sandwiched between the one or more corner conductors (20) of the power routing module (30) and one or more corner conductors (20) of the substrate (12).

15. The method of claim 14, wherein the power routing module (30) includes a bypass diode (44) for protecting the solar cells (14) from a reverse bias and the bypass diode (44) is connected to one or more of the conductors (20) of the power routing module (30).

## Patentansprüche

1. Leistungsleitmodul (30) zum elektrischen Zusammenschalten von Solarzellen (14) in einer Anordnung (22), wenn die Solarzellen (14) an einem Substrat (12) angebracht sind, wobei das Leistungsleitmodul (30) umfasst:
eine elektrisch leitende Schicht (66), die zum elektrischen Zusammenschalten der Solarzellen (14) eingerichtet ist, wobei die elektrisch leitende Schicht (66) des Leistungsleitmoduls (30) einen oder mehrere Eckleiter (20) aufweist;
eine Isolierschicht (64), die zum elektrischen Isolieren der elektrisch leitenden Schicht (66) eingerichtet ist;
einen Kleber (68) zum Anbringen des Leistungsleitmoduls (30) an dem Substrat (12); und
eine elektrische Verbindung (70) zum Verbinden des einen oder der mehreren Eckleiter (20) des Leistungsleitmoduls (30) mit einem oder mehreren Eckleitern (20) des Substrats (12); wobei jede der Solarzellen (14) zumindest eine abgeschnittene Ecke (24) aufweist, die einen Eckbereich (26) definiert, wobei die Solarzellen (14) an dem Substrat (12) derart angebracht sind, dass die Eckbereiche (26) von benachbarten der Solarzellen (14) ausgerichtet sind, wodurch eine Fläche (28) des Substrats (12) freigelegt wird;
wobei die Fläche (28) des Substrats (12) in den Eckbereichen (26) freigelegt bleibt, wenn die Solarzellen (14) an dem Substrat (12) angebracht sind; und
wobei das Leistungsleitmodul (30) an dem Substrat (12) in der Fläche (28) des Substrats (12) in den Eckbereichen (26) anbringbar ist, die freigelegt bleiben, wenn die Solarzellen (14) an dem Substrat (12) angebracht sind, so dass eine elektrische Verbindung durch die elektrische Verbindung (70) ausgebildet wird, die zwischen dem einen oder den mehreren der Eckleiter (20) des Leistungsleitmoduls (30) und dem einen oder den mehreren Eckleitern (20) des Substrats (12) eingebettet ist.

2. Leistungsleitmodul (30) nach Anspruch 1, wobei das Leistungsleitmodul (30) eine Bypassdiode (44) zum Schützen der Solarzellen (14) gegenüber einer Sperrspannung umfasst, und wobei die Bypassdiode (44) mit dem einen oder mit den mehreren der Leiter (20) des Leistungsleitmoduls (30) verbunden ist.

3. Leistungsleitmodul (30) nach einem der Ansprüche 1-2, wobei die Fläche (28) des Substrats (12) in den Eckbereichen (26), die freigelegt bleiben, Leitungskissen (72) umfassen, die Verbindungspunkte zwischen dem Leistungsleitmodul (30) und leitenden Wegen im Substrat (12) vorsehen.

4. Leistungsleitmodul (30) nach einem der Ansprüche 1-3, wobei das Leistungsleitmodul (30) zum elektrischen Zusammenschalten der Solarzellen (14) mit einer oder mehreren Leistungsleitungen im Substrat (12) eingerichtet ist.

5. Leistungsleitmodul (30) nach einem der Ansprüche 1-4, wobei das Leistungsleitmodul (30) zum elektrischen Zusammenschalten der Solarzellen (14) eingerichtet ist, indem eine serielle Verbindung zwischen den Solarzellen (14) vorgesehen wird.

6. Leistungsleitmodul (30) nach einem der Ansprüche 1-5, wobei das Leistungsleitmodul (30) zum elektrischen Zusammenschalten der Solarzellen (14) durch Brückenverbindungen um die Solarzellen (14) herum eingerichtet ist.

7. Leistungsleitmodul (30) nach einem der Ansprüche 1-6, wobei das Leistungsleitmodul (30) zum elektrischen Zusammenschalten der Solarzellen (14) in Spalten der Solarzellen (14) eingerichtet ist.

8. Leistungsleitmodul (30) nach einem der Ansprüche 1-7, wobei das Leistungsleitmodul (30) zum elektrischen Zusammenschalten der Solarzellen (14) zwischen Spalten der Solarzellen (14) eingerichtet ist.

9. Leistungsleitmodul (30) nach einem der Ansprüche 1-8, wobei die Anordnung (22) eine nicht rechtwinklige Anordnung ist und wobei das Leistungsleitmodul (30) zum elektrischen Zusammenschalten der Solarzellen (14) in der nicht rechtwinkligen Anordnung eingerichtet ist.

10. Leistungsleitmodul (30) nach einem der Ansprüche 1-9, wobei das Leistungsleitmodul (30) einen oder mehrere Leiter zum Ermöglichen einer Sperrzone (74) umfasst.

11. Leistungsleitmodul (30) nach einem der Ansprüche 1-10, wobei die Isolierschicht (64) transparent ist.

12. Leistungsleitmodul (30) nach einem der Ansprüche 1-11, wobei die elektrische Verbindung (70) mit einem Lot über einen Laserschweißvorgang oder über einen Ultraschallschweißvorgang erreicht wird.

13. Solarzellen-Panel (10), das eine Solarzellenanordnung (22) und zumindest ein Leistungsleitmodul (30) nach einem der Ansprüche 1-12 aufweist.

14. Verfahren, das aufweist:
elektrisches Zusammenschalten von Solarzellen (14) in einer Anordnung (22) unter Verwendung eines Leistungsleitmoduls (30) nach einem der Ansprüche 1-12, wobei jede der Solarzellen (14) zumindest eine abgeschnittene Ecke (24) aufweist, die einen Eckbereich (26) definiert, wobei die Solarzellen (14) an einem Substrat (12) angebracht sind, so dass die Eckbereiche (26) von benachbarten der Solarzellen (14) ausgerichtet sind, wodurch eine Fläche (28) des Substrats (12) freigelegt wird;
Anbringen der Solarzellen (14) an dem Substrat (12) derart, dass die Fläche (28) des Substrats (12) in den Eckbereichen (26) freigelegt bleibt; und
Anbringen des Leistungsleitmoduls (30) an dem Substrat (12) in der Fläche (28) des Substrats (12) in den Eckbereichen (26), die freigelegt bleiben, so dass die elektrische Verbindung durch die elektrische Verbindung (70) ausgebildet wird, die zwischen dem einen oder den mehreren der Eckleiter (20) des Leistungsleitmoduls (30) und dem einen oder den mehreren Eckleitern (20) des Substrats (12) eingebettet ist.

15. Verfahren nach Anspruch 14, wobei das Leistungsleitmodul (30) eine Bypassdiode (44) zum Schützen der Solarzellen (14) gegenüber einer Sperrspannung umfasst, und wobei die Bypassdiode (44) mit einem oder mehreren der Leiter (20) des Leistungsleitmoduls (30) verbunden ist.

## Revendications

1. Module (30) d'acheminement de puissance destiné à interconnecter électriquement des cellules solaires (14) dans un réseau (22), lorsque les cellules solaires (14) sont fixées à un substrat (12), le module (30) d'acheminement de puissance comprenant :
une couche électriquement conductrice (66) configurée pour interconnecter électriquement les cellules solaires (14), la couche électriquement conductrice (66) du module (30) d'acheminement de puissance étant constituée d'un ou de plusieurs conducteurs (20) de coin ;
une couche (64) d'isolation configurée pour isoler électriquement la couche électriquement conductrice (66) ;
un adhésif (68) servant à fixer le module (30) d'acheminement de puissance au substrat (12) ; et
un raccord électrique (70) servant à relier le ou les conducteurs (20) de coin du module (30) d'acheminement de puissance à un ou plusieurs conducteurs (20) de coin du substrat (12) ; chacune des cellules solaires (14) présentant au moins un coin rogné (24) qui définit une région (26) de coin, les cellules solaires (14) étant fixées au substrat (12) de telle façon que les régions (26) de coin de cellules adjacentes parmi les cellules solaires (14) soient alignées, exposant ainsi une zone (28) du substrat (12) ;
la zone (28) du substrat (12) dans les régions (26) de coin restant exposée lorsque les cellules solaires (14) sont fixées au substrat (12) ; et
le module (30) d'acheminement de puissance pouvant être fixé au substrat (12) dans la zone (28) du substrat (12) dans les régions (26) de coin, qui reste exposée lorsque les cellules solaires (14) sont fixées au substrat (12), de telle façon qu'une connexion électrique soit formée par le raccord électrique (70) pris en sandwich entre le ou les conducteurs (20) de coin du module (30) d'acheminement de puissance et le ou les conducteurs (20) de coin du substrat (12).

2. Module (30) d'acheminement de puissance selon la revendication 1, le module (30) d'acheminement de puissance comprenant une diode (44) de dérivation destinée à protéger les cellules solaires (14) d'une polarisation inversée et la diode (44) de dérivation étant reliée au(x) conducteur(s) parmi les conducteurs (20) du module (30) d'acheminement de puissance.

3. Module (30) d'acheminement de puissance selon l'une quelconque des revendications 1 à 2, la zone (28) du substrat (12) dans les régions (26) de coin qui reste exposée comprenant des plages conductrices (72) qui constituent des points de connexion entre le module (30) d'acheminement de puissance et des trajets conducteurs dans le substrat (12).

4. Module (30) d'acheminement de puissance selon l'une quelconque des revendications 1 à 3, le module (30) d'acheminement de puissance étant configuré pour interconnecter électriquement les cellules solaires (14) avec une ou plusieurs lignes de puissance dans le substrat (12).

5. Module (30) d'acheminement de puissance selon l'une quelconque des revendications 1 à 4, le module (30) d'acheminement de puissance étant configuré pour interconnecter électriquement les cellules solaires (14) en assurant un branchement en série entre les cellules solaires (14).

6. Module (30) d'acheminement de puissance selon l'une quelconque des revendications 1 à 5, le module (30) d'acheminement de puissance étant configuré pour interconnecter électriquement les cellules solaires (14) par des connexions de pontage autour des cellules solaires (14).

7. Module (30) d'acheminement de puissance selon l'une quelconque des revendications 1 à 6, le module (30) d'acheminement de puissance étant configuré pour interconnecter électriquement les cellules solaires (14) au sein de colonnes des cellules solaires (14).

8. Module (30) d'acheminement de puissance selon l'une quelconque des revendications 1 à 7, le module (30) d'acheminement de puissance étant configuré pour interconnecter électriquement les cellules solaires (14) entre des colonnes des cellules solaires (14).

9. Module (30) d'acheminement de puissance selon l'une quelconque des revendications 1 à 8, le réseau (22) étant un réseau non rectangulaire et le module (30) d'acheminement de puissance étant configuré pour interconnecter électriquement les cellules solaires (14) dans le réseau non rectangulaire.

10. Module (30) d'acheminement de puissance selon l'une quelconque des revendications 1 à 9, le module (30) d'acheminement de puissance comprenant un ou plusieurs conducteurs destiné à permettre une zone interdite (74).

11. Module (30) d'acheminement de puissance selon l'une quelconque des revendications 1 à 10, la couche (64) d'isolation étant transparente.

12. Module (30) d'acheminement de puissance selon l'une quelconque des revendications 1 à 11, le raccord électrique (70) étant réalisé à l'aide d'une brasure, via un processus de soudage par laser ou via un processus de soudage par ultrasons.

13. Panneau (10) de cellules solaires comportant un réseau (22) de cellules solaires et au moins un module (30) d'acheminement de puissance selon l'une quelconque des revendications 1 à 12.

14. Procédé comportant les étapes consistant à :
interconnecter électriquement des cellules solaires (14) dans un réseau (22) à l'aide d'un module (30) d'acheminement de puissance selon l'une quelconque des revendications 1 à 12, chacune des cellules solaires (14) présentant au moins un coin rogné (24) qui définit une région (26) de coin, les cellules solaires (14) étant fixées à un substrat (12) de telle façon que les régions (26) de coin de cellules adjacentes parmi les cellules solaires (14) soient alignées, exposant ainsi une zone (28) du substrat (12) ;
fixer les cellules solaires (14) au substrat (12) de telle façon que la zone (28) du substrat (12) dans les régions (26) de coin reste exposée ; et
fixer le module (30) d'acheminement de puissance au substrat (12) dans la zone (28) du substrat (12) dans les régions (26) de coin qui reste exposée de telle façon que la connexion électrique soit formée par le raccord électrique (70) pris en sandwich entre le ou les conducteurs (20) de coin du module (30) d'acheminement de puissance et un ou plusieurs conducteurs (20) de coin du substrat (12).

15. Procédé selon la revendication 14, le module (30) d'acheminement de puissance comprenant une diode (44) de dérivation destinée à protéger les cellules solaires (14) d'une polarisation inversée et la diode (44) de dérivation étant reliée à un ou plusieurs des conducteurs (20) du module (30) d'acheminement de puissance.
